# EUROPÄISCHE PATENTSCHRIFT

(11) **EP 2 188 851 B1**
(45) Veröffentlichungstag und Bekanntmachung des Hinweises auf die Patenterteilung: **13.03.2013**
(21) Anmeldenummer: 08801969.0
(22) Anmeldetag: 10.09.2008
(51) Int. Cl.: F21K 99/00

(54) **LED-MODUL, LED-LEUCHTMITTEL UND LED LEUCHTE FÜR DIE ENERGIEEFFIZIENTE WIEDERGABE VON WEISSEM LICHT**
LED MODULE, LED ILLUMINATION MEANS, AND LED LAMP FOR THE ENERGY-EFFICIENT REPRODUCTION OF WHITE LIGHT
MODULE DEL, ÉLÉMENT LUMINEUX À DEL ET APPAREIL D'ÉCLAIRAGE À DEL POUR LA REPRODUCTION DE LUMIÈRE BLANCHE EFFICACE EN TERMES D'ÉNERGIE

(30) Priorität: 12.09.2007 DE 102007043355
(43) Veröffentlichungstag der Anmeldung: 26.05.2010
(73) Patentinhaber: Lumitech Produktion und Entwicklung GmbH, 8380 Jennesdorf (AT)
(72) Erfinder: BAUMGARTNER, Erwin, A-8042 Graz (AT); SCHRANK, Franz, A-8079 Raaba (AT)
(74) Vertreter: Eder, Thomas
(86) Internationale Anmeldenummer: PCT/EP2008/007397
(87) Internationale Veröffentlichungsnummer: WO 2009/033642

(56) Entgegenhaltungen:
- WO-A-2007/017122
- DE-A1- 19 638 667
- US-A1- 2003 067 773
- US-A1- 2004 217 364
- US-A1- 2005 117 334
- US-A1- 2005 127 381
- US-A1- 2006 138 937
- US-B1- 6 429 583
- US-B2- 6 577 073
- REGINA MUELLER-MACH ET AL: "High-Power Phosphor-Converted Light-Emitting Diodes Based on III-Nitrides" IEEE JOURNAL OF SELECTED TOPICS IN QUANTUM ELECTRONICS, IEEE SERVICE CENTER, PISCATAWAY, NJ, US, Bd. 8, Nr. 2, 1. März 2002 (2002-03-01), XP011066113 ISSN: 1077-260X

## Beschreibung

### Stand der Technik:

Es sind verschiedenste Ausführungen von EL-Leuchten bekannt, bei denen basierend auf LED's weißes Licht erzeugt wird. Im Wesentlichen sind zwei unterschiedliche Ausführungsarten bekannt. In der ersten wird die Emission von drei monochromen LED's additiv zu weiß gemischt. Meist werden dabei die Grundfarben rot, grün und blau eingesetzt, kurz oft mit RGB bezeichnet.

Die zweite Ausführungsform basiert auf dem Einsatz von Konversionsleuchtstoffen, meist kurz Phosphor genannt. Dabei wird ein Teil der primären Emission der LED (meist blau im Wellenlängenbereich von ca. 460nm) vom Phosphor absorbiert und als Sekundärstrahlung in höherer Wellenlänge wieder emittiert. Die Emissionswellenlänge kann dabei von 500 nm (grün) bis 630 nm (rot) variieren. Wenn man einen Phosphor mit Emission einer Komplementärfarbe (für blau ist dies gelb) einsetzt, kann man additiv weiße Emission realisieren. Derartige Lösungen sind in einer großen Anzahl von Patenten beschrieben, so auch z.B. in der WO 02/054502A1, DE 19638667C2, oder der WO2007/017122.

Die Nachteile der EL Leuchten nach dem Stand der Technik sind bei den RGB Ausführungen die Temperaturabhängigkeit der Emissionsfarbe, weil die einzelnen LED's unterschiedliche Temperaturkoeffizienten und auch unterschiedliches Verhalten über die Lebensdauer aufweisen. Dies kann über eine entsprechend aufwendige Steuerung bzw. Regelung ausgeglichen werden, wie z.B. in der DE60021911T2 beschrieben.

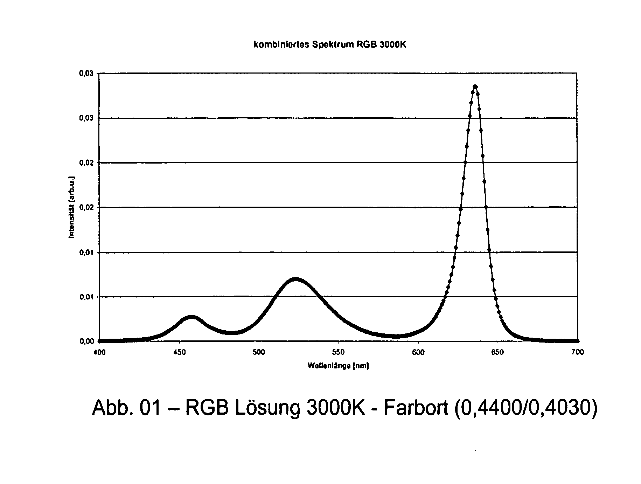

Ein weiterer essentieller Nachteil von RGB Lösungen ist die geringe Farbwiedergabe. Bei der Kombination der in Tab. 01 angeführten LED's wird ein Ra8-Wert von 22 erzielt. Das Spektrum ist in Abb. 01 dargestellt. Die Abszisse stellt die Wellenlänge in nm - die Ordinate die Intensität dar.

**Tab. 01: RGB LED's**

| **Lichtfarbe** | **x** | **y** | **Dom. Wellenl. (nm)** |
|---|---|---|---|
| blau | 0,1442 | 0,0410 | 462,9 |
| grün | 0,1983 | 0,6966 | 529,7 |
| rot | 0,7000 | 0,2996 | 627,4 |

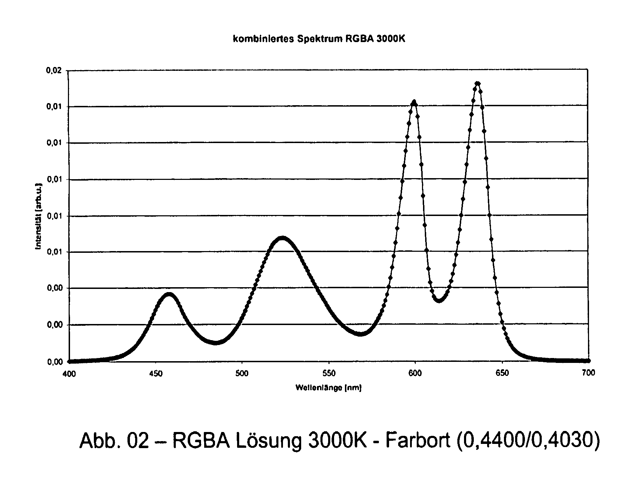

Durch das Hinzufügen von Amber-LED's kann die Farbwiedergabe erhöht werden. Bei der Kombination von der in Tab. 02 angeführten LED's wird ein Ra8 Wert von 82 erzielt. Das entsprechende Spektrum ist in Abb. 2 dargestellt. Durch diese weitere LED erhöht sich jedoch der Aufwand für Steuerung bzw. Regelung.

**Tab. 02: RGBA LED's**

| **Lichtfarbe** | **x** | **y** | **Dom. Wellenl. (nm)** |
|---|---|---|---|
| blau | 0,1442 | 0,0410 | 462,9 |
| grün | 0,1983 | 0,6966 | 529,7 |
| amber | 0,6010 | 0,3983 | 529,0 |
| rot | 0,7000 | 0,2996 | 627,4 |

Bei der Ausführung "blaue LED plus Phosphor" kann in 2 Gruppen unterteilt werden - die Gruppe der LED-Lösungen, die kaltes Licht (z.B.: 6500K) emittieren bzw. jene Gruppe, die warmes Licht (z.B.: 3000K) emittieren.

Bei Ausführungen mit Farbtemperatur 6500K ist die Effizienz hoch, die Lösung hat aber eine unzureichende Farbwiedergabe von ca. Ra8=70-75. Diese Ausführungsform ist somit nur bedingt für die Allgemeinbeleuchtung anwendbar.

Mit der Ausführung Farbtemperatur 3000K kann ein Ra8>90 erreicht werden. Ein bedeutender Nachteil dieser Lösung ist, dass die Emission des Phosphors über einen relativ weiten Wellenlängenbereich (große Halbwertsbreite) erfolgt. Die mit Phosphor erzeugte radiometrische Energie (Strahlungsleistung) wird im Wellenlängenbereich von 520 bis 800nm emittiert. Die Augenempfindlichkeitskurve V(lambda) bewertet diese Energie bei Wellenlängen ab 650nm als nur sehr gering. Daher wird unnötig Energie verschwendet.

Diese Zusammenhänge werden an Hand von Abbildungen und Tabellen näher beschrieben

### Kurzbeschreibung der Abbildungen:

Abb. 01: Stand der Technik, Spektrum RGB Lösung 3000K
Abb. 02: Stand der Technik, Spektrum RGBA Lösung 3000K
Abb. 03: Stand der Technik, Spektrum Phosphorlösung 3000K und V(lambda)
Abb. 04: Stand der Technik, Vergleich der kumulierten Strahlungsleistung mit dem kumulierten Lichtstrom
Abb. 05: CIE 1931 Normtafel
Abb. 06: Emission von Phosphoren unterschiedlicher Peakwellenlänge, dargestellt im CIE 1931 Farbraum
Abb. 07: Abnahme der Strahlungsleistung mit zunehmender Konzentration der Phosphore
Abb. 08: Effizienz der Phosphore in Lumen pro Watt als Funktion der Konzentration (dargestellt die ansteigende x-Achse der CIE 1931 Koordinaten); zur leichteren Vergleichbarkeit sind die Werte auf die blaue LED (= 1) normiert
Abb. 09: Beispiel einer Farbmischung von LED's der Gruppe P und von LED's der Gruppe R im CIE 1931 Farbraum
Abb. 10: Beispiel einer Farbmischung von LED's der Gruppe P und von LED's der Gruppe R als Spektrum dargestellt; die Hellempfindlichkeitskurve V(lambda) ist auch eingezeichnet
Abb. 11: Vergleich der kumulierten Strahlungsleistung mit dem kumulierten Lichtstrom der Versuchslampe entsprechend Abb. 09
Abb. 12: Beispiel einer Farbmischung von LED's der Gruppe P, von LED's der Gruppe B und von LED's der Gruppe R im CIE 1931 Farbraum
Abb. 13: Beispiel eines LED-Modules entsprechend des Beispieles aus Abb. 12, wobei allerdings die Leistung der LED's der Gruppe B und LED's der Gruppe R geregelt und gesteuert werden kann. Somit können alle drei dargestellten Spektren mit einem Modul realisiert werden
Abb. 14: Schaltplan für vier LED's in Serie
Abb. 15: Schaltplan für vier LED's, zwei Gruppen getrennt steuer- und regelbar
Abb. 16: Schaltplan für sechs LED's, drei Gruppen getrennt steuer- und regelbar
Abb. 17: Darstellung eines LED-Moduls mit 18 LED's; drei Gruppen getrennt steuer- und regelbar
Abb. 18: Darstellung eines LED-Leuchtmittels mit Standardsockel E27
Abb. 19: Darstellung einer LED-Leuchte mit Reflektor; es kann ein LED-Modul eingesetzt sein oder auch mehrere
Abb. 20: schematische Darstellung eines LED-Moduls mit LED's der Gruppe B und LED's der Gruppe R unter einem gemeinsamen Phosphorelement

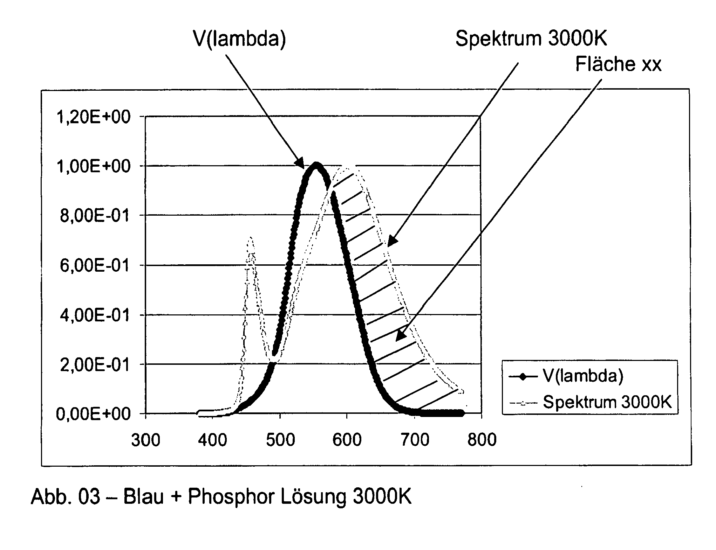

Um warmweißes Licht (2700-3500K) zu erzeugen, müssen auch rote Phosphore eingesetzt werden. Ein entsprechendes 3000K Spektrum ist in Abb. 3 dargestellt. Die Abszisse von Abb. 3 stellt die Wellenlänge in nm - die Ordinate die auf 1 normierte Intensität dar. Ebenfalls in Abb. 3 ist die Hellempfindlichkeitskurve des Auges V(lambda) enthalten.
Wichtig ist die Betrachtung des Flächenbereiches xx ab 600 Nanometer. Dieser Flächenbereich xx ergibt sich zwischen dem abfallenden Kurvenast der V(lamba) Kurve und dem Spektrum.

In diesem Bereich wird die Strahlungsleistung durch V(lambda) sehr schlecht bewertet. Dass heißt, man braucht relativ viel Energie, um wenig Licht zu erzeugen. Grund dafür ist, dass die Phosphore in einem breiten Spektrum emittieren.

**Tab. 03: 10nm Schritte - kumulierte. radiometrische Energie (Strahlungsleistung) in % und dazugehörige kumulierte Lumen in %**

| **min. nm** | **max. nm** | **3000K-mW** | **3000K-Im** |
|---|---|---|---|
| 380 | 389 | 0,01% | 0,00% |
| 390 | 399 | 0,02% | 0,00% |
| 400 | 409 | 0,03% | 0,00% |
| 410 | 419 | 0,04% | 0,00% |
| 420 | 429 | 0,08% | 0,00% |
| 430 | 439 | 0,28% | 0,01% |
| 440 | 449 | 1,48% | 0,09% |
| 450 | 459 | 4,59% | 0,43% |
| 460 | 469 | 7,19% | 0,86% |
| 470 | 479 | 8,97% | 1,30% |
| 480 | 489 | 10,23% | 1,78% |
| 490 | 499 | 11,49% | 2,52% |
| 500 | 509 | 13,13% | 4,02% |
| 510 | 519 | 15,42% | 7,11% |
| 520 | 529 | 18,34% | 12,23% |
| 530 | 539 | 21,79% | 19,23% |
| 540 | 549 | 25,67% | 27,71% |
| 550 | 559 | 29,98% | 37,36% |
| 560 | 569 | 34,73% | 47,77% |
| 570 | 579 | 39,90% | 58,38% |
| 580 | 589 | 45,42% | 68,53% |
| 590 | 599 | 51,16% | 77,55% |
| 600 | 609 | 56,93% | 84,98% |
| 610 | 619 | 62,56% | 90,65% |
| 620 | 629 | 67,91% | 94,61% |
| 630 | 639 | 72,84% | 97,10% |
| 640 | 649 | 77,31% | 98,56% |
| 650 | 659 | 81,27% | 99,33% |
| 660 | 669 | 84,71% | 99,70% |
| 670 | 679 | 87,69% | 99,87% |
| 680 | 689 | 90,23% | 99,95% |
| 690 | 699 | 92,37% | 99,98% |
| 700 | 709 | 94,16% | 99,99% |
| 710 | 719 | 95,64% | 100,00% |
| 720 | 729 | 96,87% | 100,00% |
| 730 | 739 | 97,89% | 100,00% |
| 740 | 749 | 98,72% | 100,00% |
| 750 | 759 | 99,40% | 100,00% |
| 760 | 769 | 99,96% | 100,00% |
| 770 | 779 | 100,00% | 100,00% |

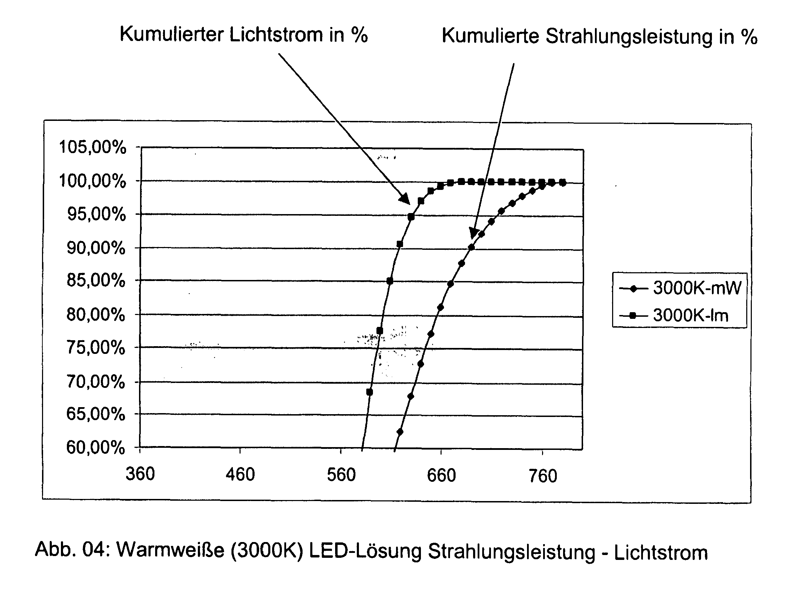

Mit 80% der radiometrischen Energie (Strahlungsleistung) werden 99% des Lichtstroms erzeugt. 20% der radiometrischen Energie (ab ca. 650nm) erzeugen nur 1 % des Lichtstroms. Abb. 4 stellt diesen Zusammenhang graphisch dar. Die Abszisse von Abb. 4 stellt die Wellenlänge in nm - die Ordinate die kumulierte Strahlungsleistung bzw. den kumulierten Lichtstrom in % dar.

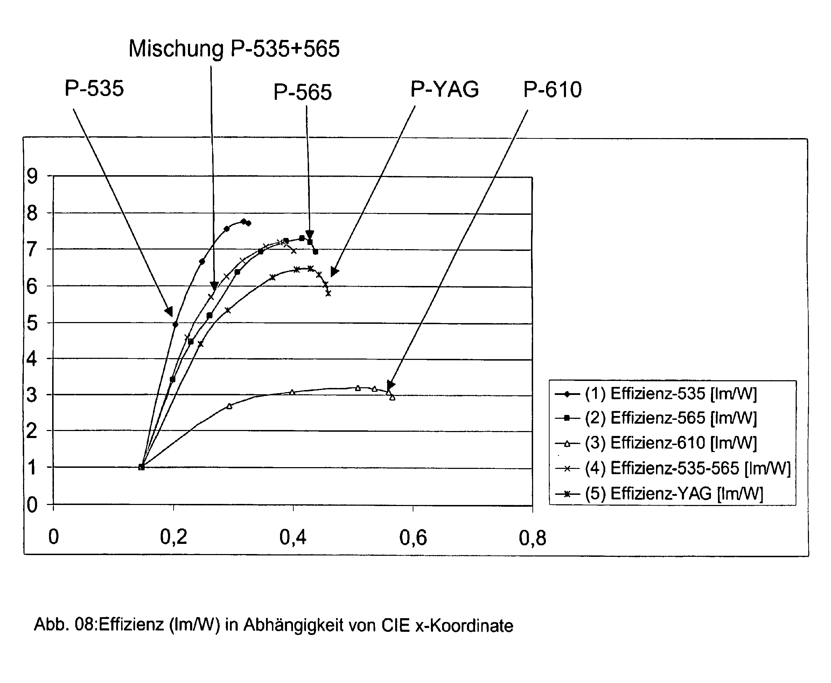

Alle Phosphor-Konversionslösungen erzeugen, verursacht durch die breite Emission der roten Phosphore und die geringere Effizienz der roten Phosphore (Abb. 08), Strahlungsleistung, die durch V(lambda) schlecht bewertet wird. Man benötigt 20 % der Strahlungsleistung um 1 % des Lichts zu erzeugen.

Neben den oben beschriebenen beiden Ausführungsformen sind auch noch Mischformen bekannt. Beispielhaft wird hier die DE10353293A1 genannt, bei der zu einer weiß emittierenden LED (mit Phosphor) bei Bedarf eine monochromatische rote LED manuell dazugeregelt werden kann. So wird eine Unterwasserlampe realisiert, wobei der Nutzer der Lampe unterschiedliche Reichweiten einzelner Spektralfarben bedingt durch eine wellenlängenabhängige Absorption in gewissen Bereichen ausgleichen kann. In der DE10216394B3 wird eine Konstruktion beschrieben, bei der neben weißen LED's (blau plus Phosphor) auch die vier Farben cyan, grün, gelb und rot eingesetzt werden. Damit erreicht man eine sehr gute Farbwiedergabe, aber keine Verbesserung der Effizienz.

In der DE20104704U1 wird die Kombination einer weißen LED mit gelb beschrieben. Das wesentliche Merkmal ist, dass der blaue Anteil mit gelb kompensiert werden soll. Offensichtlich wird ein Kaltweiß mit hohem Blauanteil eingesetzt, was auf keinen Fall die Realisierung eines LED Leuchtmittels hoher Effizienz erlaubt.

Die DE202006003878U 1 beschreibt Leuchten für Bioreaktoren, wobei für phototrope Zellkulturen möglichst jener Wellenlängenbereich eingesetzt wird, in dem die besagte Zellkultur am besten gedeiht, die einzelnen Spektralbereiche können auch einzeln angesteuert werden.

In der DE20317444U1 wird eine Straßenleuchte beschrieben, wobei der Hauptanteil in der spektralen Emission im Bereich grün liegt, es werden aber auch rot, amber, blau und weiß verwendet.

Als Nachteile entsprechend dem Stand der Technik sind ungenügende Farbwiedergabe, ineffiziente Nutzung der radiometrischen Energie (Strahlungsleistung) sowie technisch aufwendige Konstruktion zu nennen.

Die Aufgabe der vorliegenden Erfindung ist es, ein LED Modul für LED-Leuchtmittel und LED-Leuchten zur Verfügung zu stellen, das möglichst hohe Effizienz und hohe Farbwiedergabe aufweist und dabei nicht die Nachteile bestehender Lösungen aufweist.

Zur Lösung der gestellten Aufgabe ist die Erfindung durch die technische Lehre nach Anspruch 1 gekennzeichnet.

Das erfindungsgemäße LED Modul vereint die Vorteile der phosphorbasierenden LED-Lösungen mit den Vorteilen der RGB Lösungen.

### Definitionen:

### CIE 1931:

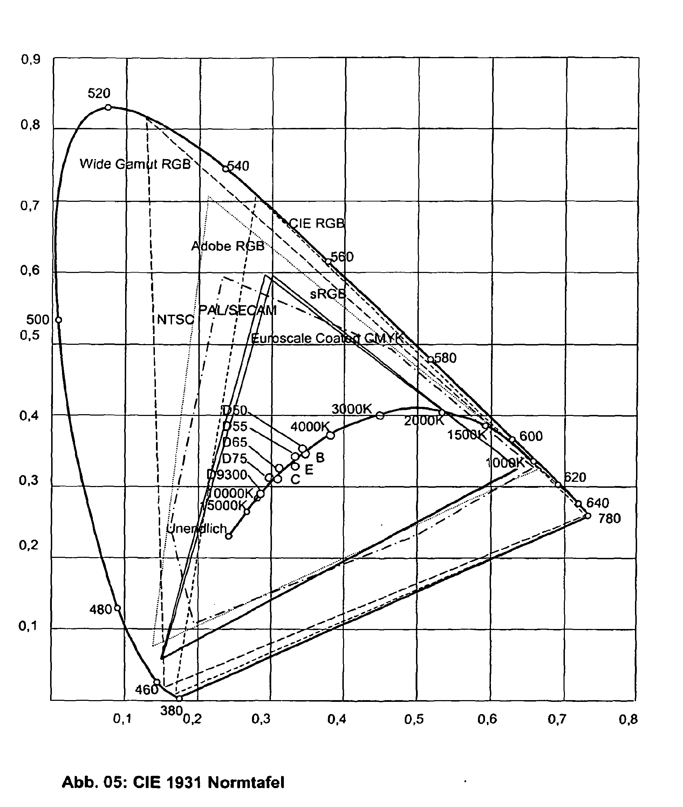

Das CIE-Normvalenzsystem oder CIE-Normfarbsystem ist die Definition der Internationalen Beleuchtungskommission (CIE - Commission internationale de l'éclairage), Farben beruhend auf dem menschlichen Farbwahrnehmungsapparat darzustellen. Diese Darstellung erlaubt es, einen Farbort mit 2 Koordinaten darzustellen Abb. 5 zeigt das CIE 1931-Diagramm. Die Abszisse stellt den x-Wert des CIE 1931 Diagramms dar- die Ordinate den γ-Wert des CIE 1931 Diagramms.

Der hufeisenförmige Bereich möglicher Farben ist bei der CIE-Normfarbtafel auf einem Koordinatensystem aufgetragen, auf dem x- und γ-Anteil (der CIEgenormten theoretischen Grundfarben X, Y und Z, (auch CIE XYZ-Farbraum genannt) einer beliebigen Farbe A, B, C, E direkt abgelesen werden können. Durch die Grundbedingung x + y + z = 1 lässt sich der z-Anteil jeweils rechnerisch (z = 1 - x - y) ermitteln. Alle möglichen Farben werden durch die Spektralfarblinie (spektral reine Farben) sowie die Purpurlinie eingefasst.

Zentraler Bezugspunkt der Tafel ist der in jeder Farbmesssituation wesentliche Weißpunkt A (ca. 3000 K). Je nach Beleuchtungssituation kann sich dieser praktisch überall innerhalb des Hufeisens befinden, technisch von Bedeutung ist jedoch nur die Black-Body Kurve, in deren Verlauf die Farben A, B, C, D, E als Temperatur eines idealen Strahlers (schwarzer Körper) in Kelvin angegeben wird. Über den verwendeten Farbraum hinaus kann die für die spezielle Situation entsprechende Spektralfarbe auf der Spektralfarblinie abgelesen werden. Auf der genau gegenüberliegenden Seite von A, B, C, D, E können die Komplementärfarben auf einer verlängerten Linie abgelesen werden. Der Punkt stellt dabei die äußerste (reinste) Komplementärfarbe dar, der in diesem Fall durch den Schnitt mit der Purpurlinie definiert wird.

Die in Abbildung 5 angegebenen Punkte A, B, C, D, E beziehen sich auf folgende Erläuterung:

Ursprünglich wurde das CIE-Normvalenzsystem vor allem in Hinsicht auf Beleuchtungsfragen entwickelt. Das System erlaubt prinzipiell jede denkbare Kombination an X-, Y- und Z-Werten, der Einfachheit und Vergleichbarkeit halber wurden jedoch bestimmte Normlichtfarben definiert - die sich alle mehr oder weniger auf der Black-Body-Kurve befinden, und einer bestimmten Farbtemperatur entsprechen.

**Tabelle 3A: Norm-Beleuchtungen nach CIE**

| CIE-Normbeleuchtung | x-Wert | γ-Wert | Bemerkung |
|---|---|---|---|
| CIE-Normbeleuchtung A | 0,4476 | 0,4074 | Lichtspektrum einer Glühlampe ähnlich |
| CIE-Normbeleuchtung B | 0,3484 | 0,3516 | - |
| CIE-Normbeleuchtung C | 0,3101 | 0,3162 | Weißpunkt der NTSC-TV-Norm |
| CIE-Normbeleuchtung E | 1/3 | 1/3 | Weißpunkt des CIE-RGB-Farbraumes; X, Y und Z zu exakt gleichen Anteilen |
| D5000 bzw. D50 | 0,3457 | 0,3585 | Weißpunkt für Wide-Gamut-RGB und Color-Match-RGB |
| D5500 bzw. D55 | 0,3324 | 0,3474 | Lichtspektrum ähnlich dem von durchschnittlichem Tageslicht, Spektrum einem Schwarzkörper bei 5500 Kelvin ähnlich |
| D6500 bzw. D65 | 0,312713 | 0,329016 | Weißpunkt für sRGB, Adobe-RGB und die PAUSECAM-TV-Norm, |
| | | | Spektrum einem Schwarzkörper bei 6504 Kelvin ähnlich |
| D7500 bzw. D75 | 0,2990 | 0,3149 | Spektrum einem Schwarzkörper bei 7500 Kelvin ähnlich |
| D9300 | 0,2848 | 0,2932 | Spektrum einem Schwarzkörper bei 9300 Kelvin ähnlich |

### Standardfarbtemperaturen:

Standardisierte Farben mit folgenden Farbtemperaturen können mit x,y-Koordinaten wie folgt dargestellt werden

**Tabelle 4: CIE 1931 Koordinaten von Standardfarbtemperaturen**

| Farbe | x-CIE 1931 | y-CIE 1931 |
|---|---|---|
| 6500K | 0,313 | 0,337 |
| 5000K | 0, 346 | 0,359 |
| 4000K | 0,380 | 0,380 |
| 3500K | 0,409 | 0,394 |
| 3000K | 0,440 | 0,403 |
| 2700K | 0,463 | 0,420 |

### Phosphore:

Darunter versteht man allgemein Leuchtstoffe, die die Strahlung einer bestimmten Wellenlänge absorbieren und Strahlung in einer anderen Wellenlänge aussenden (emittieren). Die emittierte Strahlung hat in der Regel eine größere Wellenlänge. Die Anregung des Phosphors erfolgt dabei im UV Bereich oder auch im sichtbaren Bereich. Erhältliche Phosphore werden meist in weiten Wellenlängenbereichen angeregt, man spricht von Anregungsspektren. Auch die Emission erfolgt nicht bei einer Wellenlänge, sondern auch über einen bestimmten Wellenlängenbereich. So werden zur Charakterisierung der Phosphore immer mehrere Kenngrößen angegeben, wie Peak-Wellenlänge, dominante Wellenlänge, Halbwertsbreite (Bereich in nm bei einer Intensität von 50% des Maximums) oder Farbort im CIE(1931) Farbraum. Die Emissionswellenlänge bestimmt die Farbe des ausgesendeten Lichtes. Die Quantenausbeute gibt an, welche Anteile der absorbierten Strahlung wieder emittiert werden.

Für die Erzeugung von weißem Licht mit LED's sind vor allem solche Typen von Interesse, die eine primäre Strahlung mit einer dominanten Wellenlänge von ca. 460 nm absorbieren und Licht im Wellenlängenbereich von 500 bis 630 nm Peakwellenlänge emittieren. Derartige Lösungen sind in einer großen Anzahl von Patenten beschrieben, beispielhaft wird hier auf die bereits vorher zitierten Patente WO02/054502A1 oder der DE19638667C2 verwiesen.

Beispielhaft sind in Tabelle 5 Phosphore dargestellt:

**Tabelle 5: Peak-Wellenlängen und CIE 1931 Koordinaten von Phosphoren**

| Phosphor-Bezeichnung | Peak-Wellenlänge [nm] | CIE 1931 x | CIE 1931 y |
|---|---|---|---|
| P-535 | 533 | 0.342 | 0,608 |
| P-565 | 564 | 0,448 | 0,538 |
| P-610 | 610 | 0,568 | 0,430 |
| P-YAG | 559 | 0,451 | 0,531 |

Die oben genannten Phosphore sind Standardtypen, die kommerziell in Produktionsmengen verfügbar sind. Wesentlich für den günstigen Einsatz sind die Peak-Wellenlänge und der Farbort im CIE Farbraum

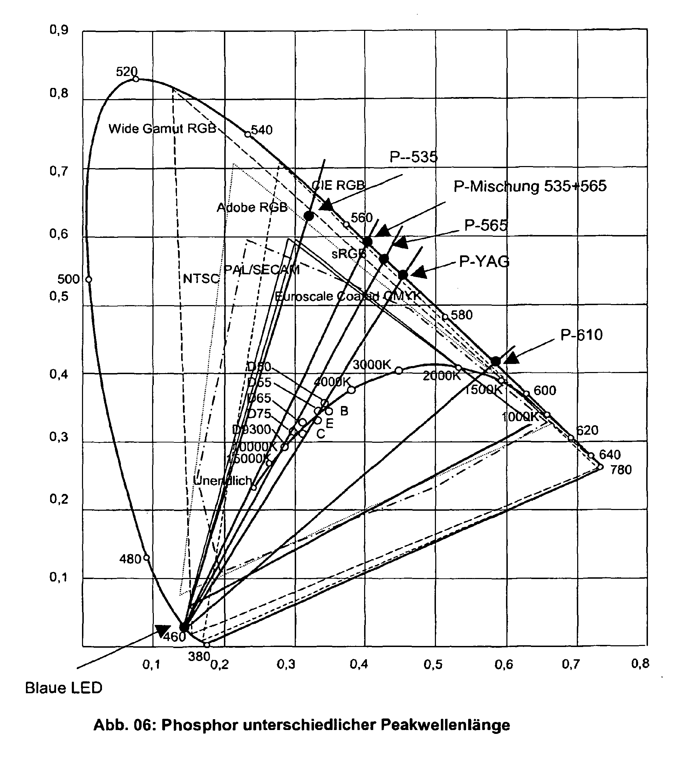

Abb. 06 zeigt beispielhaft die Farbmischung von blauen LED's mit Phosphoren. Die Abszisse von Abb. 6 stellt die x-Koordinate- die Ordinate die γ-Koordinate des CIE 1931 Diagramms dar. In Abhängigkeit der Konzentration des Phosphors, bzw. der Mischung von Phosphoren, kann jeder Punkt auf der Linie zwischen der blauen LED und dem Phosphor (bzw. der Mischung) eingestellt werden.

### Effizienz:

Neben den oben beschriebenen Prozessen der Absorption und Emission, treten in der Anwendung der Phosphore immer auch Lichtstreuung und Reflexion auf. Diese beiden Prozesse führen zu einer Verminderung der Lichtausbeute.

Wenn über eine LED mit dominanter Wellenlänge von ca. 460 nm Phosphorelemente mit zunehmender Konzentration des Phosphors angeordnet werden, kann durch Messungen der Strahlungsleistung [in Watt] sofort gezeigt werden, dass die Verluste mit der Konzentration des Phosphors ansteigen.

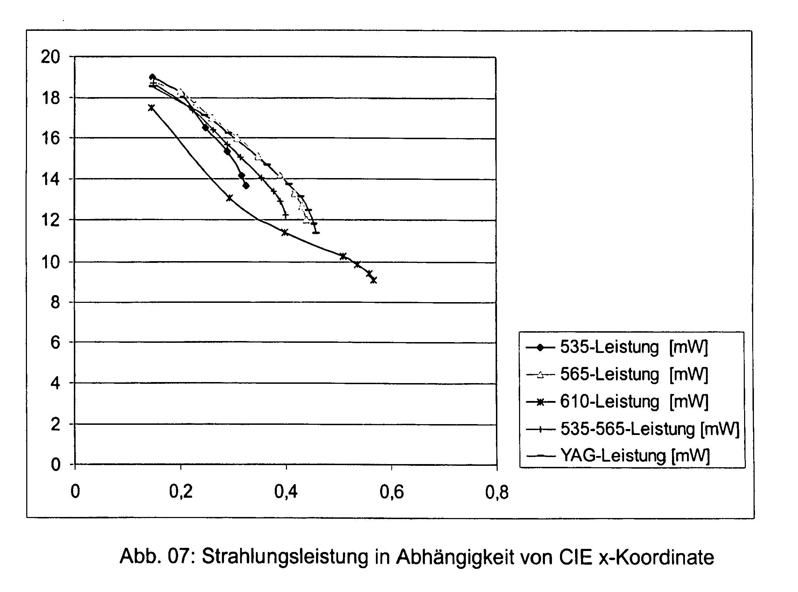

Abb. 07 verdeutlicht diesen Zusammenhang. Die Abszisse von Abb. 7 stellt die x-Koordinate des CIE 1931-Diagramms und die Ordinate die Strahlungsleistung in mW dar. Hier wird deutlich, dass bei zunehmender Konzentration des Phosphors die Strahlungsleistung deutlich abnimmt. Dieser Zusammenhang ist für alle uns derzeit bekannten und für Messungen zugänglichen Phosphore gültig.

Für die Anwendung als Lichtquelle ist aber eine Gewichtung entsprechend der Augenempfindlichkeit (V-lambda) erforderlich. Führt man diese Gewichtung durch und betrachtet nun die Lichtintensität (in Lumen) als Funktion der Phosphorkonzentration steigt zuerst die Intensität an, durchläuft ein Maximum und nimmt dann wieder ab. Das heißt, ab einer gewissen Menge an Phosphor dominieren die Verluste. Abb. 08 verdeutlicht diesen Zusammenhang.

Die Abszisse von Abb. 8 stellt die x-Koordinate des CIE 1931-Diagramms und die Ordinate die auf die blaue LED normierte Effizienz (Im/W) dar.

Dies bedeutet für die Effizienz der Lichtquelle, dass für jede eingesetzte Phosphortype ein Maximum an Effizienz, angegeben in Lumen/Watt existiert. Abbildung 08 zeigt, dass der Phosphor P-535 die maximale Effizienz bei CIE 1931 x-Koordinate x ca. 0,31 hat.

Abbildung 08 zeigt ebenso, dass der Phosphor P-565 die maximale Effizienz bei CIE 1931 x-Koordinate x ca. 0,41 hat. Abbildung 08 zeigt weiters, dass der Phosphor P-610 die maximale Effizienz bei CIE 1931 x-Koordinate über einen Wertebereich von x ca. 0,39 bis x ca. 0,56 hat. Weiters zeigt Abb. 8, dass Phosphore unterschiedliche Effizienzmaxima besitzen. Phosphor P-535 ist effizienter als Phosphor P-565.

Die Erfindung nutzt die Erkenntnis, ein LED-Leuchtmittel nur so zu betreiben, dass der die Strahlung emittierende Phosphor jeweils in seinem Effizienz-Maximum (oder in einem Bereich um das Maximum herum) betrieben wird.

Es wird zwar bevorzugt, den Betrieb im Maximum selbst auszuführen. Die Erfindung umfasst jedoch auch eine Betriebsweise in einem Bereich von bis zu minus 20 % des Maximums des jeweiligen Phosphors bzw. der Phosphormischungen. Man stellt also einen Farbwert ein, der diesem Maximum entspricht oder nahe liegt.

### Gruppe B:

Gruppe B ist eine Leuchtdiode oder mehrere Leuchtdioden mit einer dominanten Wellenlänge im Wertebereich zwischen 380nm-480nm. Ebenso kann Gruppe B durch mehrere Leuchtdioden mit unterschiedlichen dominanten Wellenlängen im Wertebereich zwischen 380-480nm gebildet werden.

### Gruppe G:

Gruppe G ist eine Leuchtdiode oder mehrere Leuchtdioden mit einer dominanten Wellenlänge im Wertebereich zwischen 500nm-560nm. Ebenso kann Gruppe G durch mehrere Leuchtdioden mit unterschiedlichen dominanten Wellenlängen im Wertebereich zwischen 500-560nm gebildet werden.

### Gruppe R:

Gruppe R ist eine Leuchtdiode oder mehrere Leuchtdioden mit einer dominanten Wellenlänge im Wertebereich zwischen 600nm-640nm. Ebenso kann Gruppe R durch mehrere Leuchtdioden mit unterschiedlichen dominanten Wellenlängen im Wertebereich zwischen 600-640nm gebildet werden.

### Gruppe P:

Gruppe P ist eine Leuchtdiode oder mehrere Leuchtdioden, wobei Leuchtdioden der Gruppe B Phosphore anregen. Die Konzentration der Phosphore/Phosphormischungen wird so gewählt, dass die photometrische Effizienz (Im/W) beim Maximum oder nahe dem Maximum liegt.

### Erfindung

Der erfindungsgemäße Lösungsansatz nutzt die im Bereich des Maximums der Effizienz (Im/W)) erzielte Effizienz der Phosphore (Gruppe P), um daraus weißes Licht zu erzeugen.

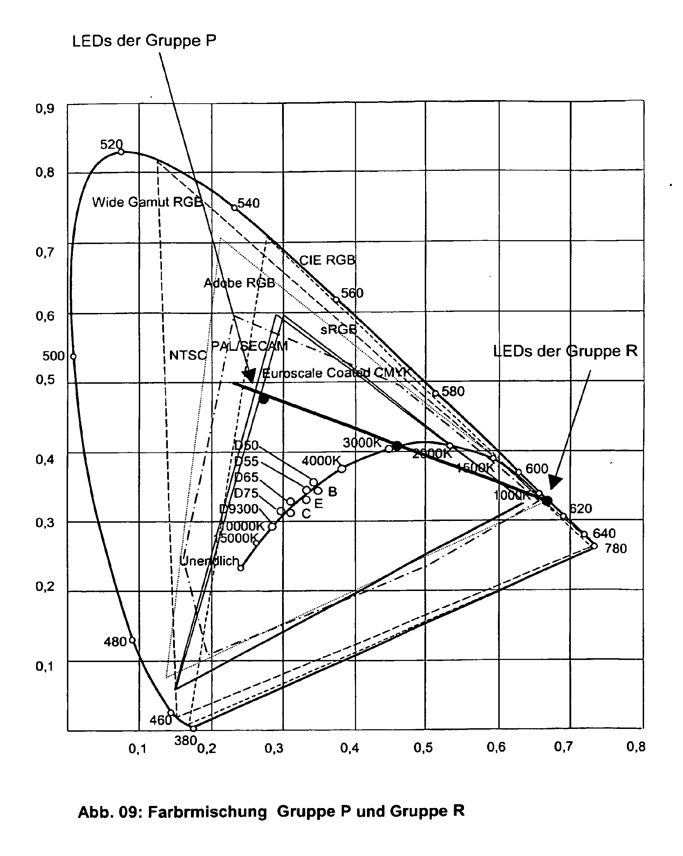

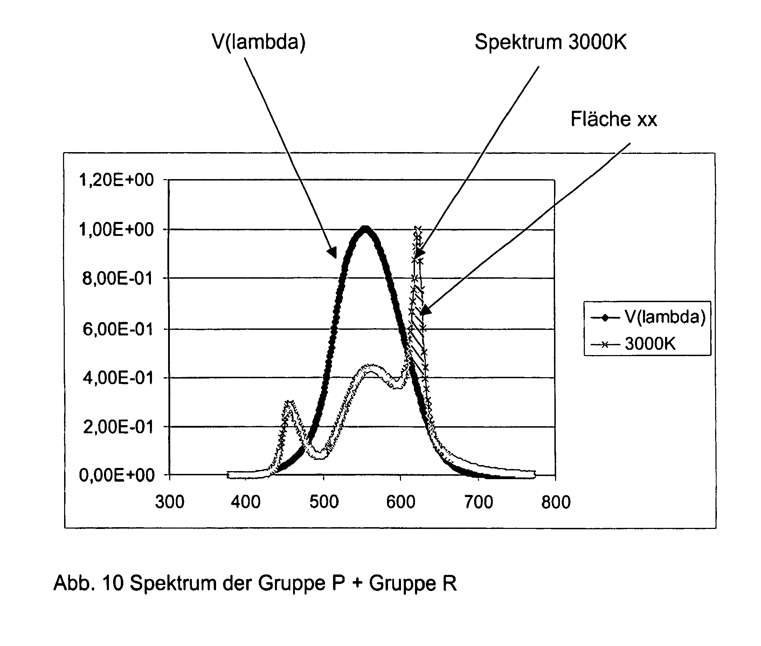

Abb. 09 stellt diese Farbmischung im CIE 1931 dar. Hier wird warmweißes Licht der Farbemperatur 3000K mittels Farbmischung von LED's der Gruppe P und Gruppe R erzeugt. Das Spektrum der Farbmischung ist in Abb. 10 dargestellt. Die Abszisse von Abb. 10 stellt die Wellenlänge in nm - die Ordinate die Intensität in mW dar. Weiters ist die V(lamda)-Kurve in Abb. 10 dargestellt. Diese Mischung von LED's der Gruppe P mit LED's der Gruppe R stellt eine optimale Energiebilanz zwischen Strahlungsleistung und photometrischer Effizienz (Im/W) dar. Die Farbwiedergabe Ra8 beträgt 91. Diese optimale Energiebilanz nach der Erfindung entsteht durch die Nutzung der höchsten Effizienz der Phosphore (Gruppe P) kombiniert mit der Reduktion der Fläche xx am abfallenden Kurvenast der V(lambda) Kurve (Nutzung der Gruppe R). Der schraffierte Bereich zeigt die stark gegenüber dem Stand der Technik (Abb. 3) minimierte Fläche xx in Abb. 10. Aus dieser minimierten Fläche xx in Abb. 10 ergibt sich der wesentliche Vorteil der Erfindung im Vergleich zum Stand der Technik.

Die Lösungen nach dem Stand der Technik versuchen mittels Farbkonversion (Phosphore) genau die Plancksche Kurve zu treffen. Die Erfindung geht bewusst von diesem Weg ab und nutzt beispielhaft die maximale Effizienz des Phosphors (Gruppe P) in Verbindung mit der geringen Halbwertsbreite der LED's der Gruppen B und R. Denn in den Bereichen geringer Gewichtung durch die V(lambda) Kurve ist eine geringe Halbwertsbreite von Vorteil

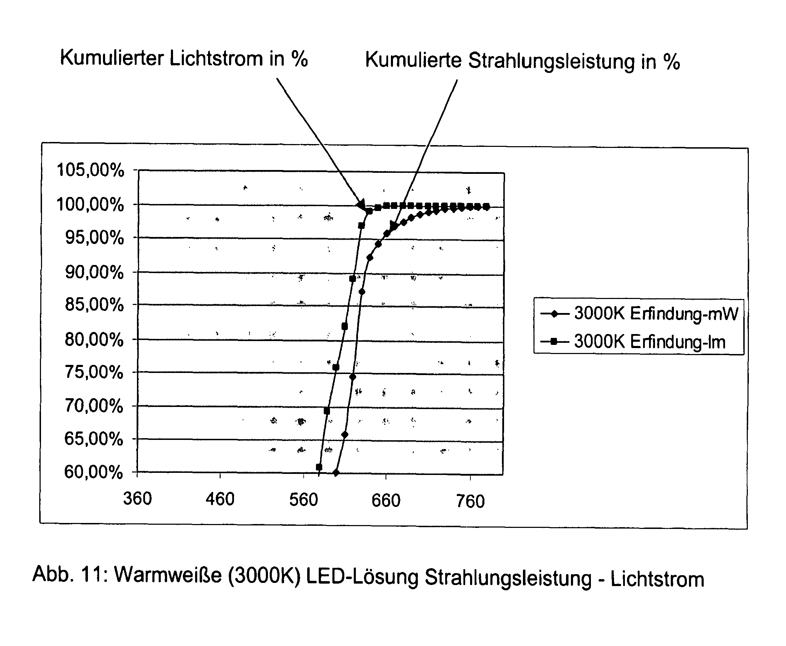

Entsprechende Messwerte eines Versuchsmusters sind in Tabelle 6 und Abb. 11 zu finden. Durch die Beimischung von LED's der Gruppe R zu LED's der Gruppe P entsteht weißes Licht. Das somit erzeugte Spektrum zeigt Abb. 10.

**Tab. 06: 10nm Schritte - kumulierte radiometrische Energie (Strahlungsleistung) in % und dazugehörige kumulierte Lumen in %**

| **min.** | **max.** | **3000K Erfindung-mW** | **3000K Erfindung-Im** |
|---|---|---|---|
| 380 | 389 | 0,01 % | 0,00% |
| 390 | 399 | 0,02% | 0,00% |
| 400 | 409 | 0,03% | 0,00% |
| 410 | 419 | 0,06% | 0,00% |
| 420 | 429 | 0,13% | 0,00% |
| 430 | 439 | 0,50% | 0,01% |
| 440 | 449 | 2,14% | 0,11% |
| 450 | 459 | 5,94% | 0,45% |
| 460 | 469 | 9,27% | 0,90% |
| 470 | 479 | 11,51% | 1,36% |
| 480 | 489 | 12,92% | 1,80% |
| 490 | 499 | 14,05% | 2,34% |
| 500 | 509 | 15,50% | 3,44% |
| 510 | 519 | 17,82% | 6,03% |
| 520 | 529 | 21,28% | 11,04% |
| 530 | 539 | 25,89% | 18,75% |
| 540 | 549 | 31,40% | 28,67% |
| 550 | 559 | 37,43% | 39,80% |
| 560 | 569 | 43,57% | 50,89% |
| 570 | 579 | 49,47% | 60,88% |
| 580 | 589 | 54,98% | 69,24% |
| 590 | 599 | 60,18% | 75,98% |
| 600 | 609 | 65,86% | 81,98% |
| 610 | 619 | 74,59% | 89,12% |
| 620 | 629 | 87,24% | 96,87% |
| 630 | 639 | 92,27% | 99,04% |
| 640 | 649 | 94,40% | 99,62% |
| 650 | 659 | 95,80% | 99,85% |
| 660 | 669 | 96,84% | 99,94% |
| 670 | 679 | 97,63% | 99,98% |
| 680 | 689 | 98,24% | 99,99% |
| 690 | 699 | 98,70% | 100,00% |
| 700 | 709 | 99,05% | 100,00% |
| 710 | 719 | 99,31% | 100,00% |
| 720 | 729 | 99, 51% | 100,00% |
| 730 | 739 | 99,67% | 100,00% |
| 740 | 749 | 99,78% | 100,00% |
| 750 | 759 | 99,87% | 100,00% |
| 760 | 769 | 99,94% | 100,00% |
| 770 | 779 | 100,00% | 100,00% |

Abb. 11 stellt diesen Zusammenhang graphisch dar. Die Abszisse von Abb. 11 stellt die Wellenlänge in nm - die Ordinate die kumulierte Strahlungsleistung bzw. den kumulierten Lichtstrom in % dar.

92% der Strahlungsleistung erzeugen 99% des Lichtstroms. 8% der radiometrischen Energie (ab 650nm) erzeugen 1 % des Lichtstroms (siehe Abb. 11).

Mit der erfindungsgemäßen Ausführung wird es ermöglicht, dass ein LED-Modul, ein LED-Leuchtmittel bzw. eine LED-Leuchte sowohl eine hervorragende Effizienz, als auch eine sehr gute Farbwiedergabe aufweist. Verglichen mit einer rein auf Phosphor basierten Lösung ist die Effizienz (bei vergleichbarer Farbwertwiedergabe) um mindestens 20% verbessert. In einem realisierten Beispiel, das aufgebaut und geprüft wurde, wurde eine Energie-Einsparung von 25 % erreicht.

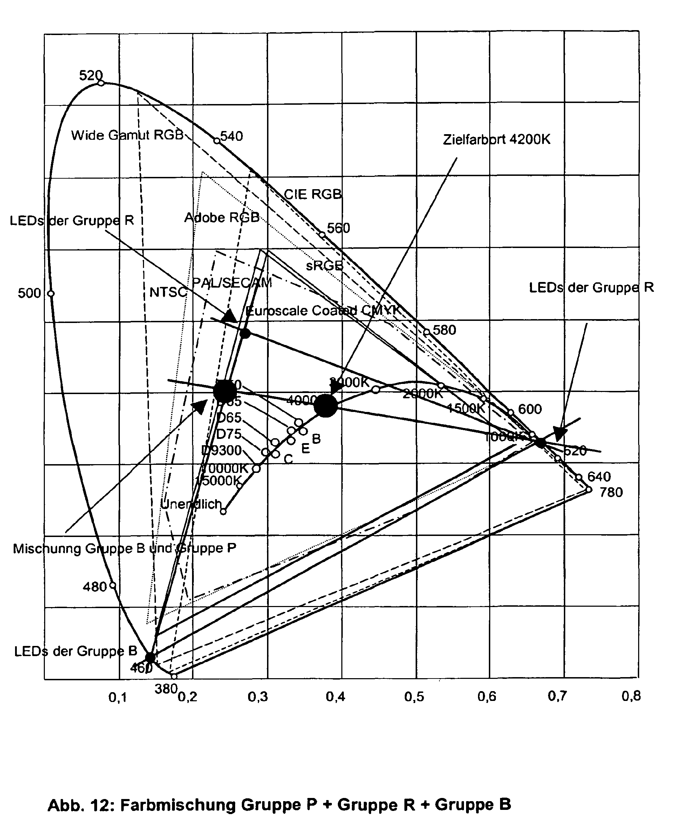

Ein weiterer essentieller Vorteil dieser Lösung ist, dass durch das Hinzufügen von LED's der Gruppe B (blaue LED's) sehr einfach die Farbtemperatur stufenlos geregelt bzw. gesteuert werden kann. Somit wird ein Farbraum aufgespannt, der zwischen den Eckpunkten der jeweiligen Gruppen (Gruppe B, Gruppe P, Gruppe R) liegt und somit alle Farben innerhalb dieses Farbraums abgebildet werden können. Abb. 12 zeigt den durch die 3 Gruppen aufgespannten Farbraum.

Insbesondere kann somit weißes Licht entlang der Planckschen Kurve sehr effizient und mit hoher Farbwiedergabe erzeugt werden. Entsprechende Messwerte eines Versuchsmusters zeigen, dass die Farbtemperatur zwischen 2500 und 8000K steuer- bzw. regelbar ist und die Farbwiedergabe Ra8 über den gesamten Farbtemperaturbereich bei ca. 90 liegt.

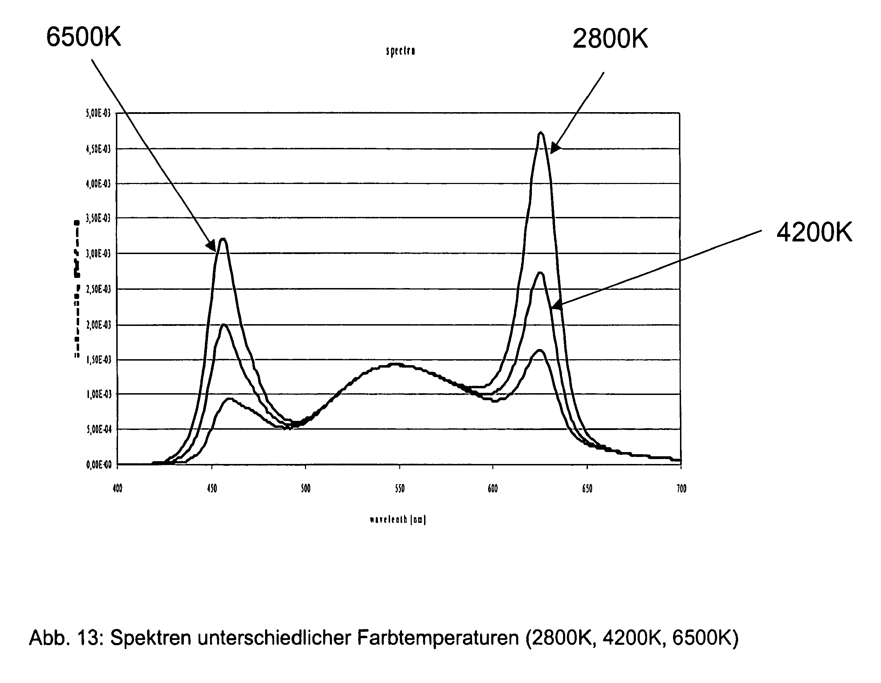

Die Einstellung einer Farbtemperatur z.B. 4200K erfolgt derart, dass ausgehend vom Farbort der Gruppe P die Intensität der Gruppe B solange erhöht wird, dass der gewünschte Mischfarbort auf der Geraden zwischen den Punkten der Gruppe P und Gruppe B erzeugt wird. Die Intensität der Gruppe R muss solange erhöht werden, bis der Zielfarbort (z.B.: 4200K) auf der Plankschen Kurve erreicht wird. Abb. 12 zeigt die Mischung der 3 Gruppen zum Zielfarbort 4200K. Abb. 13 zeigt die Spektren der Farborte 2800K, 4200K und 6500K.

Eine bevorzugte Ausbildung des LED-Moduls ist ein erfindungsgemäßes LED-Modul auf COB (Chip on Board) Basis.

Eine weitere vorteilhafte Ausführung eines LED-Moduls ist dadurch gekennzeichnet, dass die LED's der Gruppe P und die LED's der Gruppe R unter einer gemeinsamen Farbkonversionsschicht angeordnet sind.

In einer weiteren vorteilhaften Ausbildung basiert das erfindungsgemäße LED Modul auf SMD-LED Bauelementen.

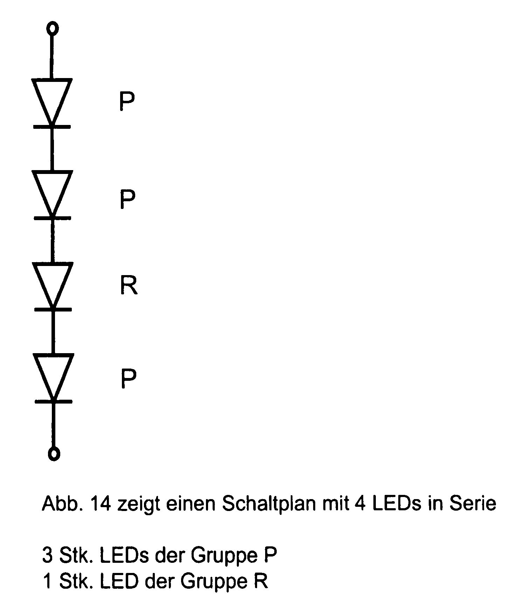

In der Abbildung 14 ist als erstes Ausführungsbeispiel eine Serienschaltung mehrerer LED's zur Erreichung des Farbortes dargestellt.
Es werden 3 Stück LED's der Gruppe P mit einer LED der Gruppe R als LED-Modul ausgebildet.

Die Anzahl der gewählten LED's hängt von der Leistungsfähigkeit der einzelnen LED's ab. Die Anzahl der LED's und deren Verhältnis zueinander ist deshalb nicht einschränkend zu verstehen.

Das Verhältnis könnte auch 2 : 1 sein oder 4 : 2 oder dergleichen.

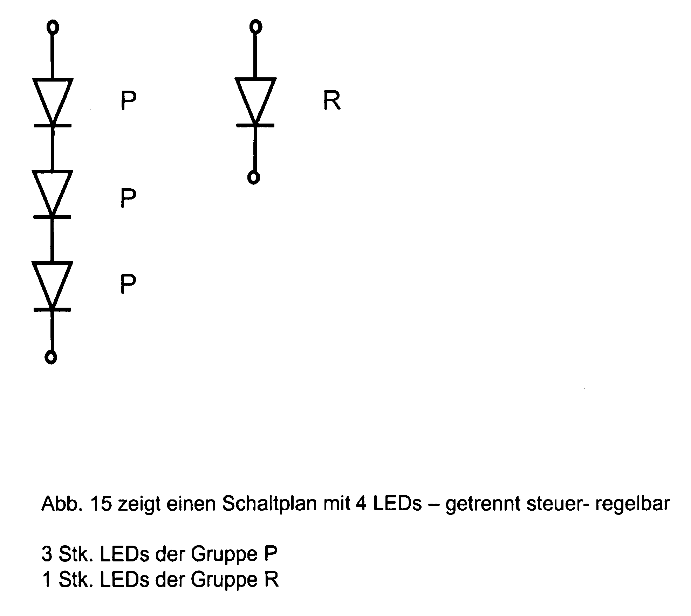

Die Abbildung 15 zeigt als abgewandeltes Ausführungsbeispiel, dass die LED's der Gruppe P getrennt von den LED's der Gruppe R angesteuert werden können. Damit ist eine genauere Regelung möglich. Es kann die Planck'sche Kurve für den jeweiligen Farbort noch genauer getroffen werden.

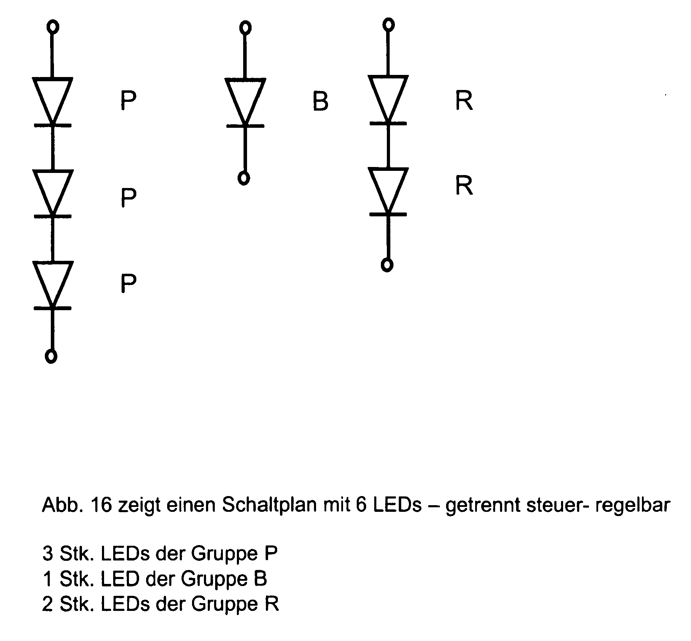

Abb. 16 zeigt einen Schaltplan mit 6 LED's, wieder getrennt steuerbar. Zusätzlich zu den LED's der Gruppe P und Gruppe R werden LED's der Gruppe B eingesetzt. Mit dieser Ausführung kann die Farbtemperatur im Bereich von 2500K bis 8000K eingestellt werden.

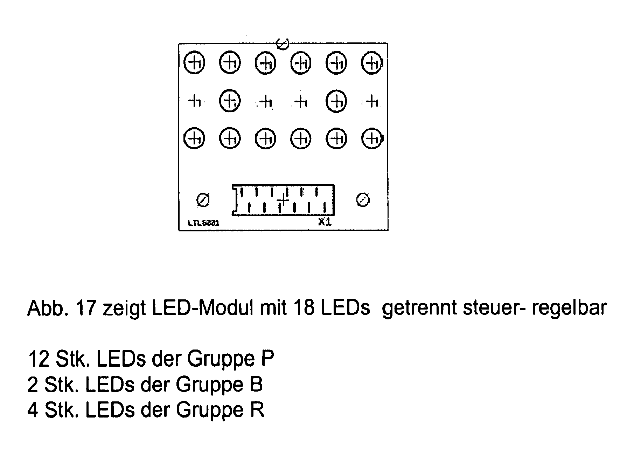

Die Abbildung 17 zeigt ein COB LED Modul mit 18 LED's inkl. Steckverbinder. Die Farbtemperatur kann zwischen 2500K-8000K gesteuert bzw. geregelt werden. Das dargestellte Modul hat derzeit eine Effizienz von 601m/W über den gesamten Regelbereich sowie einen Ra8 Wert von über 90.

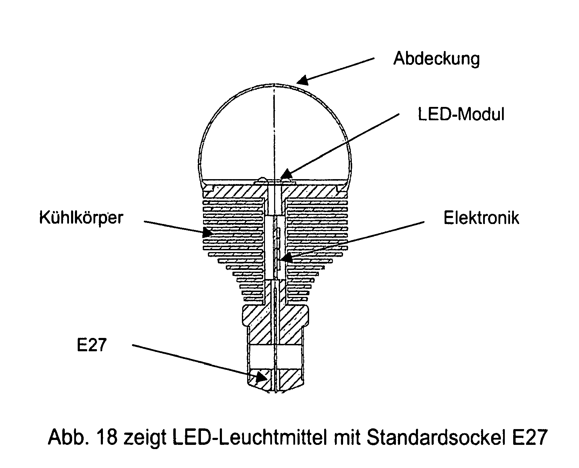

In der Abb. 18 ist ein erfindungsgemäßes LED Modul und die zugehörige Elektronik in einem Gehäuse eingebaut, wobei der elektrische Anschluss und die Form und die Abmessungen so gewählt werden, dass ein normiertes Standardleuchtmittel ersetzt werden kann. Insbesondere normierte Glühlampen, normierte Halogenglühlampen oder normierte Fluoreszenzlampen und kompakte Fluoreszenzlampen. Solche normierten Lampen können insbesondere nach einem der Standards E** (insbesondere E27), G*, GU*, M*, B* oder T* definiert sein. Das erfindungsgemäße LED-Modul kann also verbaut in Standard-Leuchtmitteln eine Glühlampe, etc. nach einem dieser Standards erfolgreich ersetzen.

Ein LED-Leuchtmittel nach Figur 18 hat derzeit eine beispielhafte Leistungsaufnahme von 8 bis 10 Watt elektrischer Leistung und eine Lichtleistung im Bereich von 500 und 600 Lumen. Dass heißt, die hier aufgenommenen 10 Watt entsprechen hinsichtlich der Lichtleistung ungefähr der einer 60 Watt- Glühlampe. Mit der in Figur 18 beschriebenen Variante werden ca. 80 % der Energie erspart.

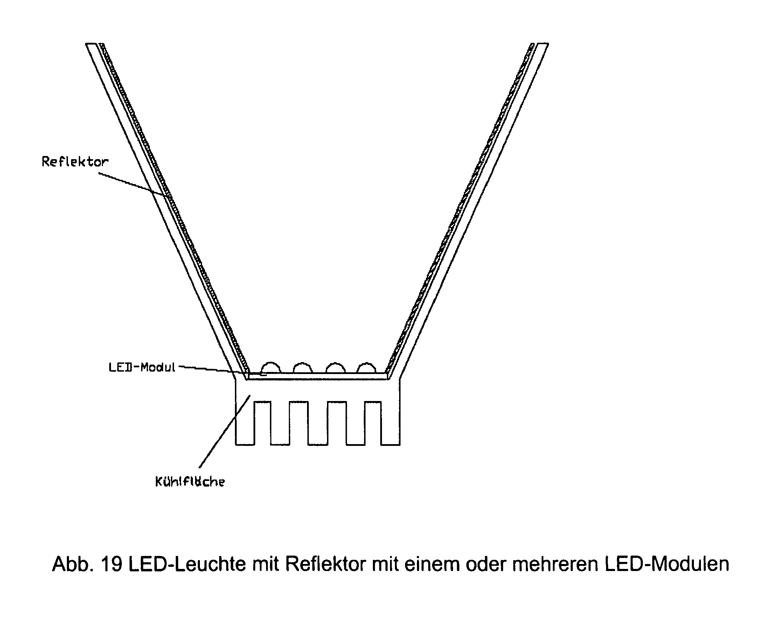

In der Abbildung 19 ist ein LED-Leuchtmittel mit einem oder mehreren der vorher beschriebenen LED-Module ausgerüstet.
Die Abdeckung dient als Staubschutz und/oder als Diffusor. Der Kühlkörper weist Kühlrippen auf, die eine günstige Wärmeableitung gewährleisten.

Abb. 19 zeigt ein erfindungsgemäßes LED Modul eingebaut in eine Leuchte. Dort ist das LED-Modul in einen Reflektor eingebaut, an dessen Bodenfläche Kühlkörper angeordnet sind. Durch den Winkel des Reflektors ist die Abstrahlcharakteristik in einen zentralen Mittenbereich konzentriert. Dies ist ein Beispiel, um zu zeigen, dass das LED-Modul auch in eine Leuchte eingebaut werden und nicht nur als Leuchtmittel verwendet werden kann.

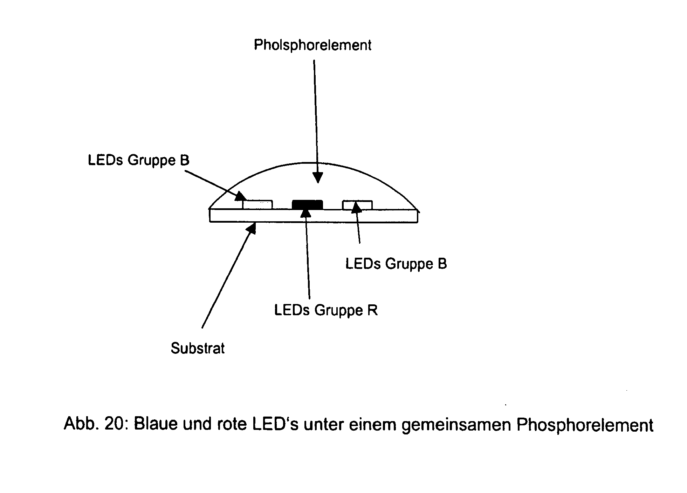

Abb. 20 zeigt schematisch ein LED-Modul mit LED's der Gruppe B und LED's der Gruppe R unter einem gemeinsamen Phosphorelement. Diese Ausführung ist besonders vorteilhaft im Hinblick auf die Mischung der spektralen Anteile, der Einsatz eines Diffusorelementes kann entfallen.

Das hier gezeigte integrierte Leuchtmittel vereinigt auf kleinstem Raum LED's der Gruppe P und LED's der Gruppe R auf einem gemeinsamen Substrat. Sie sind auf dem Substrat elektrisch leitfähig kontaktiert.

Die LED's der Gruppe B regen den Phosphor zur Strahlung an, der seine Konversionsstrahlung nach außen abgibt. Weil die Strahlung der LED's der Gruppe R durch den Phosphor nicht beeinflusst wird, ergibt sich an der Oberfläche des abdeckenden Phosphorelementes der gewünschte weiße Lichteindruck der additiven Mischung von Strahlung der Gruppe P und der Gruppe R.

Zusammenfassend werden die wesentlichen Merkmale der Erfindung in Form einer kurzen Aufzählung wiedergegeben:
- LED Modul mit optimaler Energiebilanz - Effizienz
- LED Modul mit Ra8 ≥ 85, typ. 90 - 95
- LED Modul aufgebaut in COB Technologie oder SMD Technologie
- LED's unterschiedlicher Gruppen unter einem Phosphorelement
- Erfindungsgemäßes LED Modul für LED Leuchtmittel mit Standardsockel (z.B.: E27)
- Leuchten mit erfindungsgemäßen LED Modulen mit Reflektor
- Leuchten mit erfindungsgemäßen LED Modulen mit Linsen
- LED Module mit steuer- und regelbarer Farbtemperatur

Das erfindungsgemäße LED-Modul erzeugt sehr effizient weißes Licht einer hohen Qualität (Ra8>85). Daher ist dieses LED-Modul bevorzugt für Anwendungen in der Allgemeinbeleuchtung, Shopbeleuchtung, Officebeleuchtung, Museumsbeleuchtung, Medizintechnik, Industriebeleuchtung etc. einsetzbar.

Die steuer- regelbare Farbtemperatur erlaubt eine stufenlose Veränderung der S/P-Ratio (skotopisch/photopisch). Somit kann dieses LED-Modul vorteilhaft in der Straßenbeleuchtung eingesetzt werden. Durch die stufenlose Änderung der Farbtemperatur werden die Bedürfnisse des menschlichen Auges beim Dämmerungssehen (mesopisch) berücksichtigt.

**Tabelle 07: S/P-Ratio der Muster entsprechend Abb. 13**

| **Farbtemperatur** | **S/P-Ratio** |
|---|---|
| 2800K | 1,4 |
| 4200K | 1,8 |
| 6500K | 2,3 |

## Patentansprüche

1. LED-Modul bestehend aus
(a) mindestens einer LED einer Gruppe P von LEDs, welche eine oder mehrere, Phosphore oder Phosphormischungen anregende LEDs einer Gruppe B von LEDs umfasst, wobei die Gruppe B von LEDs eine oder mehrere LEDs mit einer dominanten Wellenlänge im Bereich von 380 nm bis 480 nm umfasst, und
(b) mindestens einer LED einer Gruppe R von LEDs, wobei die Gruppe R von LEDs eine oder mehrere LEDs mit jeweils einer dominanten Wellenlänge im Bereich von 600 nm bis 640 nm umfasst, und/oder
(c) mindestens einer LED der Gruppe B und/oder
(d) mindestens einer LED der Gruppe G, wobei die Gruppe G von LEDs eine oder mehrere LEDs mit jeweils einer dominanten Wellenlänge im Bereich von 500 nm bis 560 nm umfasst,
(e) wobei die Strahlungen der mindestens einen LED der Gruppe P und der mindestens einen weiteren LED additiv gemischt sind,
**dadurch gekennzeichnet,**
(f) **dass** die Konzentration des Phosphors oder der Phosphormischung der wenigstens einen LED der Gruppe P so gewählt ist, dass deren in Im/W gemessene photometrische Effizienz in Abhängigkeit von der CIE x-Koordinate im Maximum oder nicht mehr als 20% unter dem Maximum liegt, und
(g) **dass** die wenigstens eine LED der Gruppe P und die wenigstens eine weitere LED so ausgebildet und so ansteuerbar sind,
(i) **dass** weißes Licht erzeugt wird und der Farbort des weißen Lichts auf oder nahe der Planck'schen Kurve liegt, und
(ii) **dass** die Farbwiedergabe Ra8 mindestens 85 beträgt.

2. LED-Modul nach Anspruch 1, **dadurch gekennzeichnet, dass** das LED-Modul ausschließlich aus LEDs der Gruppe P und Gruppe R besteht und dass das erzeugte weiße Licht eine fixe Farbtemperatur im Bereich zwischen 2500 K und 8000 K aufweist.

3. LED-Modul nach Anspruch 1, **dadurch gekennzeichnet, dass** das LED-Modul ausschließlich aus LEDs der Gruppe P und Gruppe B besteht, und dass das erzeugte weiße Licht eine fixe Farbtemperatur im Bereich zwischen 5000 K und 8000 K aufweist.

4. LED-Modul nach Anspruch 1, **dadurch gekennzeichnet, dass** das LED-Modul ausschließlich aus LEDs der Gruppe P und Gruppe G besteht, dass der Phosphor der LEDs der Gruppe P eine Peakwellenlänge im Wertebereich zwischen 590-640 nm besitzt und dass das erzeugte weiße Licht eine fixe Farbtemperatur im Bereich zwischen 2500 K und 8000 K aufweist.

5. LED-Modul nach Anspruch 1, **dadurch gekennzeichnet, dass** das LED-Modul aus LEDs der Gruppe P und Gruppe R und Gruppe B besteht und derart steuer-oder regelbar ist, dass die Farbtemperatur des erzeugten weißen Lichts stufenlos innerhalb zumindest eines Teilbereichs desjenigen Bereichs der Planck'schen Kurve einstellbar ist, der sich innerhalb des Farbraums befindet, der durch die Farborte der LEDs der Gruppe P, der Gruppe R und der Gruppe B aufgespannt wird.

6. LED-Modul nach Anspruch 5, **dadurch gekennzeichnet, dass** das LED-Modul derart steuer- oder regelbar ist, dass die Farbtemperatur des erzeugten weißen Lichts stufenlos im Bereich von 2500 bis 8000 K einstellbar ist.

7. LED-Modul nach einem der Ansprüche 1, 2, 5 oder 6, **dadurch gekennzeichnet, dass** LED's der Gruppe B und LED's der Gruppe R unter einer gemeinsamen Farbkonversionsschicht angeordnet sind.

8. LED-Modul nach Anspruch 1, **dadurch gekennzeichnet, dass** das LED-Modul aus LEDs der Gruppe P und Gruppe G und Gruppe B besteht und derart steuer-oder regelbar ist, dass die Farbtemperatur des erzeugten weißen Lichts stufenlos innerhalb zumindest eines Teilbereichs desjenigen Bereichs der Planck'schen Kurve einstellbar ist, der sich innerhalb des Farbraums befindet, der durch die Farborte der LEDs der Gruppe P, der Gruppe G und der Gruppe B aufgespannt wird, wobei der Phosphor der Gruppe P eine Peakwellenlänge im Wertebereich zwischen 590-640 nm besitzt.

9. LED-Modul nach Anspruch 8, **dadurch gekennzeichnet, dass** das LED-Modul derart steuer- oder regelbar ist, dass die Farbtemperatur des erzeugten weißen Lichts stufenlos im Bereich von 2500 bis 8000 K einstellbar ist.

10. Standard-Leuchtmittel mit einem LED-Modul nach einem der Ansprüche 1-9.

## Claims

1. An LED module consisting of
(a) at least one LED of a group P of LEDs which comprises one or more LEDs that excite phosphors or phosphor mixtures and are from a group B of LEDs, wherein the group B of LEDs comprises one or more LEDs with a dominant wavelength in the range of 380 nm to 480 nm, and
(b) at least one LED of a group R of LEDs, wherein the group R of LEDs comprises one or more LEDs with, in each case, a dominant wavelength in the range of 600 nm to 640 nm, and/or
(c) at least one LED of the group B and/or
(d) at least one LED of the group G, wherein the group G of LEDs comprises one or more LEDs with, in each case, a dominant wavelength in the range of 500 nm to 560 nm,
(e) wherein the emissions of the at least one LED of the group P and of the at least one further LED are mixed additively,
**characterised in that**
(f) the concentration of the phosphor or of the phosphor mixture of the at least one LED of the group P is selected in such a way that the photometric efficiency thereof, measured in lm/W, as a function of the CIE x-coordinate lies at a maximum or not more than 20% below the maximum, and
(g) the at least one LED of the group P and the at least one further LED are formed and can be activated in such a way
(i) that white light is generated, and the colour locus of the white light lies on or near the Planck's curve, and
(ii) that the colour rendition Ra8 amounts to at least 85.

2. An LED module according to claim 1, **characterised in that** the LED module consists exclusively of LEDs of the group P and group R, and **in that** the white light that is generated has a fixed colour temperature in the range between 2500 K and 8000 K.

3. An LED module according to claim 1, **characterised in that** the LED module consists exclusively of LEDs of the group P and group B, and **in that** the white light that is generated has a fixed colour temperature in the range between 5000 K and 8000 K.

4. An LED module according to claim 1, **characterised in that** the LED module consists exclusively of LEDs of the group P and group G, **in that** the phosphor of the LEDs of the group P has a peak wavelength in the range of values between 590-640 nm, and **in that** the white light that is generated has a fixed colour temperature in the range between 2500 K and 8000 K.

5. An LED module according to claim 1, **characterised in that** the LED module consists of LEDs of the group P and group R and group B and can be controlled or regulated in such a way that the colour temperature of the white light that is generated can be adjusted steplessly within at least one partial range of that range of the Planck's curve that is located within the colour space spanned by the colour loci of the LEDs of the group P, the group R and the group B.

6. An LED module according to claim 5, **characterised in that** the LED module can be controlled or regulated in such a way that the colour temperature of the white light that is generated can be adjusted steplessly in the range of 2500 to 8000 K.

7. An LED module according to one of claims 1, 2, 5 or 6, **characterised in that** LEDs of the group B and LEDs of the group R are arranged under a common colour conversion layer.

8. An LED module according to claim 1, **characterised in that** the LED module consists of LEDs of the group P and group G and group B and can be controlled or regulated in such a way that the colour temperature of the white light that is generated can be adjusted steplessly within at least one partial range of that range of the Planck's curve that is located within the colour space spanned by the colour loci of the LEDs of the group P, the group G and the group B, wherein the phosphor of the group P has a peak wavelength in the range of values between 590-640 nm.

9. An LED module according to claim 8, **characterised in that** the LED module can be controlled or regulated in such a way that the colour temperature of the white light that is generated can be adjusted steplessly in the range of 2500 to 8000 K.

10. A standard lighting means having an LED module according to one of claims 1-9.

## Revendications

1. Module à DEL constitué de
(a) au moins une DEL d'un groupe P de DEL, qui comprend une ou plusieurs DEL excitant du phosphore ou des mélanges de phosphore d'un groupe B de DEL, dans lequel le groupe B de DEL comprend une ou plusieurs DEL avec une longueur d'ondes dominante sur une plage de 380 nm à 480 nm, et
(b) au moins une DEL d'un groupe R de DEL, dans lequel le groupe R de DEL comprend une ou plusieurs DEL avec chacune une longueur d'ondes dominante sur une plage de 600 nm à 640 nm, et/ou
(c) au moins une DEL du groupe B et/ou
(d) au moins une DEL du groupe G, dans lequel le groupe G de DEL comprend une ou plusieurs DEL avec respectivement une longueur d'ondes dominante sur une plage de 500 nm à 560 nm,
(e) dans lequel les rayonnements de la au moins une DEL du groupe P et de la au moins une autre DEL sont mélangés de manière additive,
**caractérisé en ce que**
(f) la concentration du phosphore ou du mélange de phosphore de la au moins une DEL du groupe P est choisie de façon à ce que leur efficacité photométrique, mesurée en lm/W, se trouve, en fonction des coordonnées CIE x, au maximum ou à pas plus de 20 % sous le maximum, et
(g) la au moins une DEL du groupe P et la au moins une autre DEL sont conçues et contrôlables de telle sorte que
(i) de la lumière blanche soit produite et la localisation chromatique de la couleur de la lumière blanche se trouve sur ou près de la courbe de Planck, et
(ii) le rendu des couleurs Ra8 soit d'au moins 85.

2. Module à DEL selon la revendication 1, **caractérisé en ce que** le module à DEL est exclusivement constitué de DEL du groupe P et du groupe R, et **en ce que** la lumière blanche produite présente une température chromatique fixe sur une plage entre 2 500 K et 8 000 K.

3. Module à DEL selon la revendication 1, **caractérisé en ce que** le module à DEL est exclusivement constitué de DEL du groupe P et du groupe B, et **en ce que** la lumière blanche produite présente une température chromatique fixe sur une plage entre 5 000 K et 8 000 K.

4. Module à DEL selon la revendication 1, **caractérisé en ce que** le module à DEL est exclusivement constitué de DEL du groupe P et du groupe G, **en ce que** le phosphore des DEL du groupe P possède une longueur d'ondes maximale dans une plage de valeurs entre 590 et 640 nm, et **en ce que** la lumière blanche produite présente une température chromatique fixe sur une plage entre 2 500 K et 8 000 K.

5. Module à DEL selon la revendication 1, **caractérisé en ce que** le module à DEL est constitué de DEL du groupe P et du groupe R et du groupe B et est commandable ou réglable de telle sorte que la température chromatique de la lumière blanche produite soit ajustable en continu à l'intérieur d'au moins une partie de ladite zone de la courbe de Planck, laquelle zone se trouve à l'intérieur de l'espace chromatique de couleurs défini par les localisations chromatiques des DEL du groupe P, du groupe R et du groupe B.

6. Module à DEL selon la revendication 5, **caractérisé en ce que** le module à DEL est commandable ou réglable de telle sorte que la température chromatique de la lumière blanche produite soit ajustable en continu sur une plage de 2 500 K à 8 000 K.

7. Module à DEL selon l'une des revendications 1, 2, 5 ou 6, **caractérisé en ce que** les DEL du groupe B et les DEL du groupe R sont agencées sous une même couche de conversion chromatique.

8. Module à DEL selon la revendication 1, **caractérisé en ce que** le module à DEL est constitué de DEL du groupe P et du groupe G et du groupe B, et est commandable ou réglable de telle sorte que la température chromatique de la lumière blanche produite soit ajustable en continu à l'intérieur d'au moins une partie de ladite zone de la courbe de Planck, laquelle zone se trouve à l'intérieur de l'espace chromatique défini par les localisations chromatiques des DEL du groupe P, du groupe G et du groupe B, dans lequel le phosphore du groupe P possède une longueur d'ondes maximale sur une plage de valeurs entre 590 et 640 nm.

9. Module à DEL selon la revendication 8, **caractérisé en ce que** le module à DEL est commandable ou réglable de telle sorte que la température chromatique de la lumière blanche produite soit ajustable en continu sur une plage de 2 500 K à 8 000 K.

10. Agent lumineux standard avec un module à DEL selon l'une des revendications 1 à 9.
